# EUROPEAN PATENT APPLICATION

(11) **EP 1 841 052 A2**
(43) Date of publication of application: **03.10.2007**
(21) Application number: 07004146.2
(22) Date of filing: 28.02.2007
(51) Int. Cl.: H02M 7/538, H02M 3/158

(54) **Power converter**

(30) Priority: 31.03.2006 JP 2006098679
(71) Applicant: Hitachi, Ltd., Chiyoda-ku Tokyo (JP)
(72) Inventor: Shigeta, Satoru, Hitachi Ltd., Chiyoda-ku Tokyo 100-8220 (JP); Fujino, Shinichi, Hitachi Ltd., Chiyoda-ku Tokyo 100-8220 (JP); Hashimoto, Keita, Hitachi Ltd., Chiyoda-ku Tokyo 100-8220 (JP); Seto, Sadashi, Hitachi Ltd., Chiyoda-ku Tokyo 100-8220 (JP)
(74) Representative: Beetz & Partner

(57) **Abstract**

The present invention relates to a power converter having a high side switching device (1) and a low side switching device (2) that are connected in series between a positive power supply terminal and a negative side power supply terminal for direct current, the connection point between the high side switching device (1) and the low side switching device (2) being set as an output terminal, and each of the high side switching device (1) and the low side switching device(2) being constructed by a switching device to which a current mirror device (1-2, 2-2) is appended, further including a high side current detecting unit (7) for detecting current flowing in the current mirror device (1-2) of the high side switching device (1), and a low side current detecting unit (8) for detecting current flowing in the current mirror device (2-2) of the low side switching device (2). A signal detected by the high side current detecting unit (7) and a signal detected by the low side current detecting unit (8) are differentiated from each other and set as a current value of the output terminal.

## Description

### BACKGROUND OF THE INVENTION

### 1. Field of the Invention

The present invention relates to a power converter having an output current detecting function, and particularly a power converter suitable for a servo system, a DC/DC converter, a three-phase AC inverter, etc.

### 2. Description of the Related Art

It is usually the case that in order to control a power converter for a servo system, a DC/DC converter, a three-phase AC converter or the like, it is required to detect the output current thereof, and thus various kinds of current sensors have been proposed. In this case, an insulating type current sensor having a core, so-called a hall sensor is known. Here, in the hall sensor, a conductor through which current to be measured flows is made to penetrate through a ring-shaped core, and magnetic field occurring by the current is read out by a hall sensor disposed in the magnetic path of the core, thereby detecting the current.

In addition to the hall sensor described above, there has been also hitherto known a shunt resistance type current sensor in which a shunt resistor is inserted in the passage of the current to be measured and a voltage drop appearing in the shunt resistor is detected (for example, see JP-A-2003-61392). Furthermore, there has been also hitherto known a current detecting method for observing an ON-voltage of MOSFET used as a switching device in a power converter for use in a field chopper circuit of a servo system or an electric motor control device and converting the observed ON-voltage to a current value (for example, see JP-A-2004-48863).

### SUMMARY OF THE INVENTION

A current sensor used for a power converter is generally required to be compact in size and low in loss and cost, and also high in precision. The conventional techniques as described above have not paid sufficient attention to these points.

In the above conventional techniques, the current sensor having the insulating core is expensive in price, and also requires a structure such as a bus bar penetrating through the sensor or the like as a passage for primary current. Therefore, the number of parts is increased, and the size of the structure is increased, so that the cost further rises up.

Furthermore, from the viewpoint of the system protection to over-current such as short-circuit or the like, it is required to provide a current detecting circuit for detecting the over-current of the switching device separately from the current sensor for detecting the output current. Accordingly, increase of the number of parts and further increase in cost are unavoidable.

Still further, the current sensor based on the shunt resistor brings a great power loss to large-current controlling equipment such as a power converter or the like, and thus the resistor for shunt is increased in size. In addition, it is required to pay attention to suppression of temperature increase due to heating, so that the large-size design and the cost-up are unavoidable.

From these viewpoints, a hopeful view has been taken on the current detection technique using the ON-voltage of MOSFET among the above-described techniques. In this case, however, the switching device is required to be turned on at the current detecting timing, and thus the period of the current detection and the ON-OFF duty cycle are restricted by each other.

For example, when current is detected by an lower arm, the lower arm is required to be perfectly turned on every current detection period, and it is impossible to detect current under the state that an upper arm is turned on by 100%. Furthermore, it takes a time from the turn-on time of the lower arm till the time when the output of the current value is stabilized, and also it takes a time to sample the current value, so that it is required to increase the ON-period of the lower arm, and the restriction to the duty of the upper arm is more remarkable.

As described above, when the duty has an upper limit value, the output voltage performance of the power converter is restricted, and for example in the case of an inverter for driving a three-phase motor, there occurs a demerit that the voltage applied to the motor is restricted and thus current cannot be made to flow at high rotation.

An object of the present invention is to provide a low-cost power converter that is compact in size and low in loss and can perform current detection with no restriction in output voltage performance.

In order to attain the above object, a power converter may have an upper arm switching device (high side switching device) and/or a lower arm switching device (low side switching device) that may be connected in series between a positive power supply terminal and a negative side power supply terminal for direct current. The connection point between the upper arm switching device and the lower arm switching device may be set as an output terminal, wherein each of the upper arm switching device and the lower arm switching device is constructed by a switching device having a mirror device (current mirror device) The power converter may be further equipped with an upper arm current detecting unit for detecting current flowing in the mirror device of the upper arm switching device and/or a lower arm current detecting unit for detecting current flowing in the mirror device of the lower arm switching device, and a signal detected by the upper arm current detecting unit and a signal detected by the lower arm current detecting unit may be differentiated from each other (i.e., the difference between both the signals is taken) and set as a current value of the output terminal.

The above converter may be equipped with an over-current protecting unit that may be operated by using at least one of the signal detected by the upper arm current detecting unit and the signal detected by the lower arm current detecting unit, whereby the same object as described above can be attained.

Furthermore, the power converter described above may be mounted in a vehicle, whereby the same object as described above can be attained.

A method of detecting mirror current may be a method of reading the mirror current by an insulating type current sensor, or a method of making mirror current flow through a shunt resistor and reading a voltage across both the ends of the shunt resistor.

According to the present invention, the difference in current between the upper arm and the lower arm is read in, and thus current can be detected even when only the upper arm may be set to 100% ON-state or only the lower arm may be set to 100% ON-state. As a result, a current sensor which is high in precision, compact in size and low in loss can be achieved without restricting an application range.

According to the present invention, the high-precision current control can be achieved, and thus a power converter having excellent current control performance can be provided in low cost . By mounting this power converter in a vehicle, a vehicle having high performance can be manufactured.

The above mentioned features may be combined in any way, partly or as a whole.

### BRIEF DESCRIPTION OF THE DRAWINGS

Fig. 1 is a block diagram showing a first embodiment of a power converter according to the present invention;
Fig. 2 is a block diagram showing a second embodiment of the power converter of the present invention; and
Fig. 3 is a block diagram showing a third embodiment of the power converter of the present invention.

### DETAILED DESCRIPTION OF THE PREFERRED EMBODIMENTS

Preferred embodiments of a power converter according to the present invention will be described hereunder with reference to the accompanying drawings.

### First Embodiment

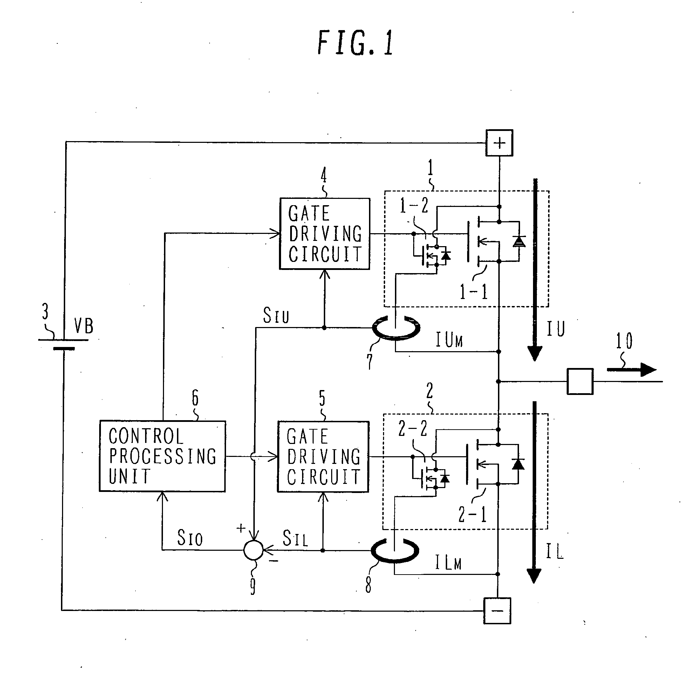

Fig. 1 shows a first embodiment in which the present invention is applied to a switching circuit used in a field chopper circuit or an electric motor control device as disclosed in JP-A-2004-48863 described above.

In the first embodiment, a switching device 1 serving as an upper arm and a switching device 2 serving as a lower arm are connected in series between a positive terminal and a negative terminal to which a DC voltage VB is applied from a DC power source 3, and current IU and IL flowing through the respective elements respectively are switched, whereby output current IO is supplied from an output terminal 0 to a load (not shown) such as a motor or the like.

Each of the switching devices 1, 2 is equipped with a gate driving circuit 4, 5, and subjected to switching control under the control of a control operating unit 6. At this time, the output current 10 of an accurate value cannot be supplied to a load such as a motor or the like at any time unless the control operating unit 6 controls the switching timing and the switching time of each of the respective switching devices 1 and 2 in accordance with the detection result of the output current IO. Therefore, as described above, the output current IO must be detected and controlled.

Therefore, according to this embodiment, as each switching device 1 (2) is used MOSFET in which a main switching device 1-1 (2-1) of MOSFET is provided with a mirror device 1-2 (2-2) of MOSFET, that is, a so-called mirror device appended MOSFET. Here, MOSFET is an electric field effect transistor (FET) of metal oxide semiconductor (MOS).

Under the state that the mirror device appended MOSFET is used as the switching device, the mirror device 1-2 (2-2) of each switching device 1 (2) is provided with a current detecting circuit 7 (8), and the current flowing through the mirror device 1-2 (2-2), that is, mirror current IU_{M} (IL_{M}) is detected by the current detecting circuit 7 (8). The detection result is taken out as a detection signal S_{IU} (S_{IL}), and input to a comparison circuit 9.

In the comparison circuit 9, the input detection signals S_{IU} and S_{IL} are differentiated from each other, and the difference result is output as a differential signal S_{IO}. This differential signal S_{IO} is input to the control operating unit 6, and the switching timing and the switching time of each of the switching devices 1 and 2 are controlled on the basis of this signal as a signal representing the output current IO.

At this time, the output current 10 is represented by the difference between the current IU flowing through the switching device 1 of the upper arm and the current IL flowing through the switching device 2 of the lower arm. Accordingly, as described above, the output current IO can be represented by the differential signal S_{IO} output from the comparison circuit 9, so that the output current IO can be controlled by supplying the differential signal S_{IO} corresponding to the difference between the detection signal S_{IU} and the detection signal S_{IL} to the control operating unit 6.

Here, it is general that the control operating unit 6 is designed so as to be equipped with a microcomputer and the control is carried out by the microcomputer. In this case, as shown in Fig. 1, the input of the output current IO to the microcomputer may be based on a system of inputting the outputs of the current detecting circuits 7 and 8 to a comparison circuit 9 comprising a differential amplifier and then inputting a differential voltage to the AD port of the microcomputer. In place of this system, the processing of directly inputting the detection signal S_{IU} of the current detection circuit 7 and the detection signal S_{IL} of the current detection circuit 8 to the AD port of the microcomputer and determining the differential voltage by software of the microcomputer may be executed.

In this case, an insulating type current sensor having a core, a so-called hall sensor is used as each of the current detection circuit 7, 8 as shown in Fig. 1 while these sensors are symbolized. As described above as the prior art, according to this sensor, a conductor serving as a passage through which current to be measured flows is made to penetrate through a ring-shaped core, and magnetic field induced by the current is read out by the hall sensor disposed in the magnetic path of the core and detected as the current. Accordingly, the size of the hall sensor is greatly dependent on the maximum value of the current to be detected.

Now, it is assumed that the maximum values of the current IU, IL flowing through the respective switching devices 1 and 2 are equal to 500A, for example. In this case, a bus bar type conductor having a remarkably large cross section area is required as the conductor serving as the passage for current, and thus the core is also large in size, so that the whole sensor is also large in size and the cost is increased.

However, at this time, the current flowing through the mirror device 1-2 (2-2) of each switching device 1 (2) corresponds to the mirror ratio of the switching device concerned. If the mirror ratio is 1000:1, the mirror current IU_{M}, IL_{M} in the above case is merely 0.5A even at maximum.

Accordingly, in this case, it is sufficient to merely insert a remarkably narrow conductor into the core. For example, it is sufficient even if an electric wire used for wiring is made to directly penetrate through the core or wounded by several turns, and also the core itself can be designed in a remarkably small size. Therefore, in this case, the compact-size and low-cost design can be easily performed.

In addition, the mirror ratio of the mirror-appended MOSFET is determined by the electrode area of the main element and the mirror device. Accordingly, from the viewpoint of the recent semiconductor manufacturing technique, it is normal that the electrode area can be easily set to a remarkably accurate value and also stabilized. This is not limited to the mirror-appended MOSFET, but also other mirror device appended switching devices, for example, mirror-appended IGBT.

Accordingly, according to the first embodiment, In addition to the miniaturization of the current detecting circuits 7 and 8 and the reduction of the cost, the precision can enhanced, so that a power converter having excellent performance can be easily provided with greatly reducing the cost.

Furthermore, accordingtothe first embodiment, hall sensors, that is, insulating type current sensors are used as the current detecting circuits 7 and 8. As a result, they can be used with paying no attention to the potential difference between the upper arm switching device 1 and the lower arm switching device 2, and thus there is a merit that a circuit for voltage isolation is not separately required.

Still furthermore, in the first embodiment, the current detecting circuit 7, 8 is individually provided to each switching device 1, 2. Therefore, if the detection signal S_{IU} is input from the current detection circuit 7 to the gate driving circuit 4 while the detection signal S_{IL} is input from the current detection circuit 8 to the gate driving circuit 5, and a gate signal output from each of the gate driving circuits 4, 5 is narrowed down when these signals exceed a predetermined threshold value, thereby interrupting the switching devices 1, 2, the switching device would be provided with an over-current protection function. Accordingly, the output terminal can be protected from short to power, short to ground, etc.

### Second Embodiment

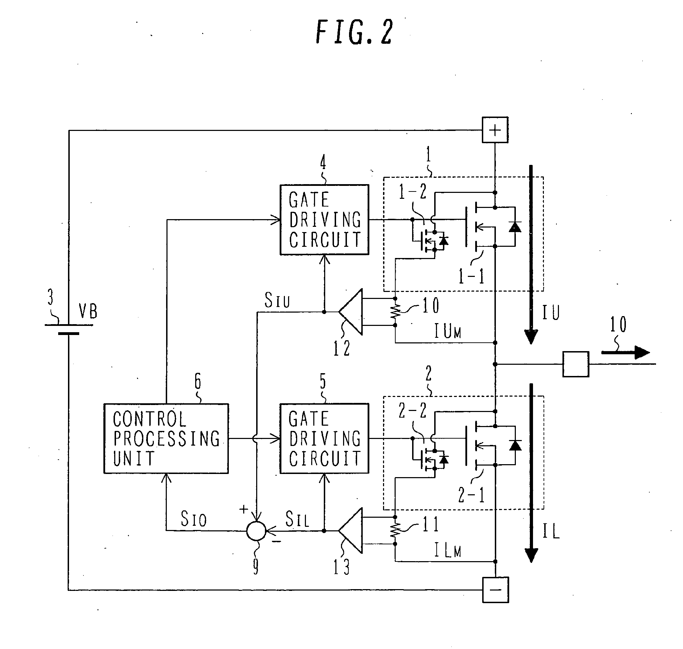

Next, a second embodiment of the present invention will be described with reference to Fig. 2.

In the second embodiment, mirror current is detected by a shunt resistor. Accordingly, as shown in Fig. 2, shunt resistors 10, 11 are inserted in the current paths of the respective mirror devices 1-2 and 2-2, and differential circuits 12 and 13 are connected to the shunt resistors 10, 11 in parallel. The other constituent elements are the same as the first embodiment shown in Fig. 1.

First, the shunt resistor 10 causes a voltage drop based on the mirror current IU_{M} of the mirror device 1-2, and the differential circuit 12 acts to detect the voltage drop and achieve a detection signal S_{IU} representing the current IU flowing through the switching device 1 of the upper arm. The shunt resistor 11 causes a voltage drop based on the mirror current IL_{M} of the mirror device 2-2, and the differential circuit 13 acts to detect this voltage drop and achieve a detection signal S_{IL} representing the current IL flowing in the switching device 2 of the lower arm.

Therefore, as shown in Fig. 2, the detection signals S_{IU}, S_{IL} are input to the comparison circuit 9 to output a differential signal S_{IO}, and the differential signal S_{IO} is input to the control operating unit 6, whereby the output current 10 can be controlled with high precision as in the case of the first embodiment shown in Fig. 1.

Here, in the case of the second embodiment, the shunt resistors 10, 11 are also inserted in the current paths of the mirror devices 1-2 and 2-2. Accordingly, the current flowing through each shunt resistor 10, 11 is remarkably smaller than the current IU, IL flowing through each switching device 1, 2.

For example, in this case, assuming that the maximum value of the current IU, IL flowing through the switching device 1, 2 is equal to 500A and the mirror ratio is equal to 1000:1, the mirror current IU_{M}, IL_{M} is also equal to 0.5A at maximum. The loss P at this time is proportion to the square of the current I.

Accordingly, according to the second embodiment, the loss based on the shunt resistors 10, 11 can be suppressed to a sufficiently small level, and thus heating is also suppressed by the amount corresponding to the suppressed level of the loss, so that the resistor can be miniaturized. As a result, according to the second embodiment, in addition to the miniaturization of the current detection circuits 7, 8 and the reduction of the cost, the precision can be enhanced, so that a power converter having excellent performance can be easily provided with greatly reducing the cost.

In the case of the embodiment shown in Fig. 2, with respect to the shunt resistor 10 constituting the voltage detecting circuit of the upper arm, the potential thereof is not fixed to zero, and also it varies from 0V to VB in accordance with the switching of the switching device 1 of the upper arm.

Accordingly, in the second embodiment, it is needless to say that the potential of the shunt resistor 10 is required to be level-shifted to the same potential as the potential of the switching device 2 of the lower arm or the control operating unit 6 by using a differential amplifier or an isolation amplifier.

### Third Embodiment

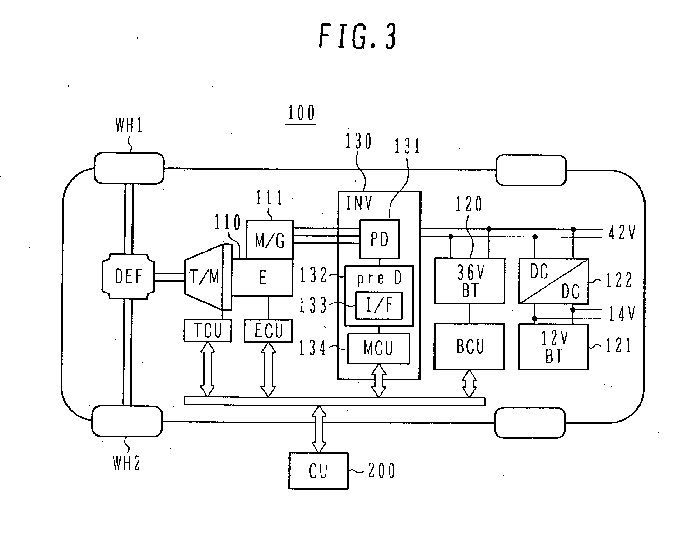

Next, a vehicle in which the power converter of the present invention is mounted will be described as a third embodiment with reference to Fig. 3. In this case, the vehicle according to the third embodiment is illustrated as a car 100, and it uses an engine 110 such as a gasoline engine or the like as a power source, for example.

When the car 100 travels, the torque of the engine 110 is transmitted to wheels WH1, WH2 through a transmission device T/M and a differential gear mechanism DEF. At this time, an M/G (dynamotor) 111 is connected to the engine 110, and M/G 111 is operated as a normal alternator, and also operated as a starter for the engine 110.

Accordingly, M/G 111 operates as the alternator (AC generator) when the engine 110 is rotating, and two secondary batteries of a main battery 120 having a terminal voltage of 36V and an auxiliary battery 121'having a terminal voltage of 12V are charged. At the start time of the engine 110, AC power is supplied from the main battery 120 to M/G 111, and M/G 111 is operated as the AC generator so that starting torque is supplied to the engine 110.

Therefore, INV (inverter device) 130 is connected to M/G 111. When M/G 111 is operated as the alternator, INV 130 is made to carry out a forward conversion operation to convert AC output of M/G 111 to DC output, so that the main battery 120 and the auxiliary battery 121 are charged. When M/G 111 is operated as the AC generator, INV 130 is made to carry out a normal reverse conversion operation to convert the DC output of the main battery 120 to three-phase AC power, and the three-phase AC power is supplied to the M/G 111, so that a torque necessary to start the engine 110 is generated.

At this time, in the case of a normal car, various kinds of electrical components such as lights, etc. are designed in conformity with specifications of a DC voltage of 12V, and thus the auxiliary battery 121 is mounted in the car to operate these electrical components. Accordingly, in order to charge the auxiliary battery 121, a DC/DC (DC/DC converter) 122 whose output voltage is based on 36V/12V specification is provided, and the auxiliary battery 121 is connected to INV 130 through the DC/DC 122.

In the embodiment shown in Fig. 3, the power converter according to the first embodiment or the second embodiment is applied to INV 130, and the mirror-appended switching device is used for PD (power device) 131 serving as a main circuit element of INV 130. This is the feature of this embodiment. As a result, high-precision current control can be performed by the miniaturized and cost-reduced INV 130.

Furthermore, the power converter according to the first embodiment or the second embodiment may be applied to DC/DC 122, and the mirror-appended switching device may be used for the switching device of the power converter. In this case, DC/DC 122 can be also miniaturized and the cost thereof can be reduced. Furthermore, high-precision current control can be performed.

At this time, PD 131 is controlled from a microcomputer 134 through an interface 133 by a driving circuit 132 in INV 130. The microcomputer 134 is controlled by a further superordinate CU (control unit) 200 for collectively controlling the overall car 100.

As described above, by applying the power converter of the first embodiment or the second embodiment to INV 130, DC/DC 122, etc., the current sensor that is high in precision, compact in size and low in loss and cost can be provided to a power converter f or a car. Furthermore, for example, when a rectangular-wave based operation is carried out by an inverter or the like, according to the embodiments of the present invention, the current detection can be performed even under the state that any one of the arms is set to 100%-ON. As a result, the voltage utilization factor can be enhanced, and high-output driving can be performed by even a compact motor. Therefore, the weight of the vehicle can be reduced.

Here, M/G 111 is operated at the AC generator at the start time of the engine as described above. However, it can be operated as an electric motor even when the vehicle runs. Accordingly, in place of the engine 110, it may be used as a driving source for a car or it may be used as an auxiliary driving source to make a car run together with the engine 110.

The above mentioned features and embodiments can be combined in any way, partly or as a whole.

## Claims

1. A power converter having a high side switching device (1) and a low side switching device (2) which are connected in series between a positive power supply terminal and a negative side power supply terminal for direct current, the connection point between the high side switching device (1) and the low side switching device (2) being set as an output terminal:
wherein each of the high side switching device (1) and the low side switching device (2) is constructed by a switching device to which a current mirror device (1-2, 2-2) is appended, and comprising;
a high side current detecting unit (7) for detecting current flowing in the current mirror device (1-2) of the high side switching device (1); and
a low side current detecting unit (8) for detecting current flowing in the current mirror device (2-2) of the low side switching device (2);
wherein a signal detected by the high side current detecting unit (7) and a signal detected by the low side current detecting unit (8) are differentiated from each other and set as a current value of the output terminal.

2. The power converter according to claim 1, further comprising an over-current protecting unit which is operated by using at least one of the signal detected by said high side current detecting unit (7) and the signal detected by said low side current detecting unit (8).

3. A vehicle having the power converter according to claim 1 or 2 mounted therein.
